# EUROPEAN PATENT APPLICATION

(11) **EP 4 716 447 A1**
(43) Date of publication of application: **25.03.2026**
(21) Application number: 25203608.2
(22) Date of filing: 22.09.2025
(51) Int. Cl.: H10W 44/20, H01F 17/00, H10W 44/00

(54) **RADIO FREQUENCY POWER AMPLIFIER DEVICE AND MANUFACTURING METHOD THEREOF**

(30) Priority: 24.09.2024 CN 202411328893
(71) Applicant: Suzhou Watech Electronics Co., Ltd., Suzhou, Jiangsu 215125 (CN)
(72) Inventor: YANG, Mengsu, Jiangsu, 215125 (CN)
(74) Representative: Michalski Hüttermann & Partner Patentanwälte mbB

(57) **Abstract**

A radio frequency power amplifier device includes an active device, a grounded capacitor device, and an inductor assembly disposed on the grounded capacitor device. The inductor assembly is connected between the active device and the grounded capacitor device. The radio frequency power amplifier device and manufacturing method thereof of the embodiment of the present disclosure connect the inductor assembly between the active device and the grounded capacitor device, which is capable of improving the electromagnetic coupling problem due to the two bonding wires existing the parallel components in the conventional solution, so as to reduce the loss of the output signals, and improve the power amplifier efficiency.

## Description

### TECHNICAL FIELD

The present disclosure relates to the technical field of semiconductors, and more particularly to a radio frequency power amplifier device and a manufacturing method thereof.

### BACKGROUND

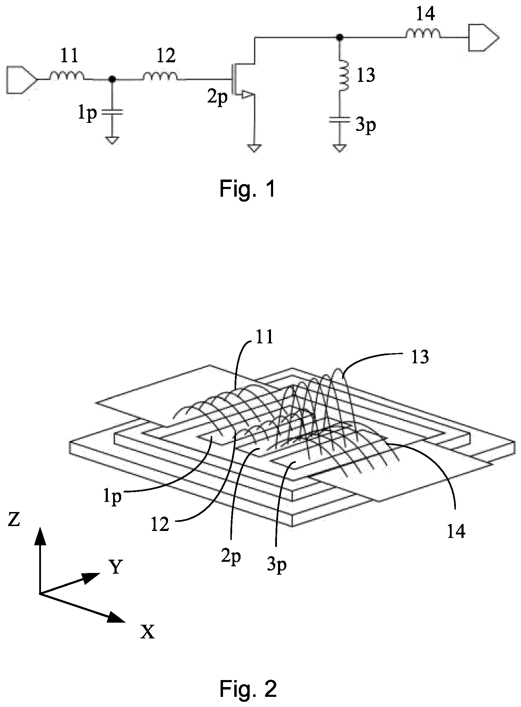

A radio frequency power amplifier device is a radio frequency device/module that amplifies weak radio frequency signals through a series of active or passive electronic component combinations and sends the signals to the antenna for transmission. A high-power amplifier applied in base stations usually adopts a discrete radio frequency power amplifier device, as shown in Fig. 1. The discrete radio frequency power amplifier device comprises: an input matching capacitor chip 1p, an active device 2p as a driving device, and a grounded capacitor device 3p, which has a simple structure.

Fig. 2 is a conventional physical implementation of the above radio frequency power amplifier device. As shown in Fig. 2, the input matching capacitor chip 1p, the active device 2p, and the grounded capacitor device 3p are formed on a substrate side by side. A first lead wire 11 between the input matching capacitor chip 1p and an input port, a second lead wire 12 between the input matching capacitor chip 1p and the active device 2p, a third lead wire 13 between the active device 2p and the grounded capacitor device 3p, and a fourth lead wire 14 between the active device 2p and the output port are formed an equivalent inductance, respectively. Each of the first lead wire 11, the second lead wire 12, the third lead wire 13, and the fourth lead wire 14 is defined as an equivalent inductance as shown in Fig. 1.

In the above solution, the third lead wire 13 and the fourth lead wire 14 have the same lead out direction, and have parallel components in the X-axis and the Z-axis, so that the inductances formed by the third lead wire 13 and the fourth lead wire 14 have mutual inductance effects, causing a strong electromagnetic coupling, resulting in a large loss of the output signal, and reducing the power amplifier efficiency.

### SUMMARY

In order to solve one of the above-described technical defects, the embodiment of the present disclosure provides a radio frequency power amplifier device and a manufacturing method thereof.

According to a first aspect of the embodiment of the present disclosure, a radio frequency power amplifier device is provided and comprises: an active device, a grounded capacitor device, and an inductor assembly.

The inductor assembly is disposed on the grounded capacitor device, and the inductor assembly is connected between the active device and the grounded capacitor device.

According to a second aspect of the embodiment of the present disclosure, a manufacturing method of the radio frequency power amplifier device is provided, and comprises:
disposing an active device and a grounded capacitor device on a frame substrate;
disposing an inductor assembly on the grounded capacitor device, to electrically connect the inductor assembly and the grounded capacitor; and
connecting the inductor assembly and the active device with a plurality of bonding wires.

The technical solution provided by the present disclosure, the radio frequency power amplifier device comprises: the active device, the grounded capacitor device, and the inductor assembly; the inductor assembly is disposed on the ground capacitor device; the inductor assembly is connected between the active device and the grounded capacitor device, the inductor assembly comprises: an inductor base and a conductive wire; the inductor base is provided with a plurality of through holes penetrating the thickness of the inductor base, and the conductive wire interleavedly passes through the plurality of through holes on two sides of the inductor base from side to side by turns, to form an inductor with a certain three-dimensional space, which is capable of improving the electromagnetic coupling problem due to the two bonding wires existing the parallel components in the conventional solution, so as to reduce the loss of the output signals, and improve the power amplifier efficiency.

### BRIEF DESCRIPTION OF THE DRAWINGS

The drawings described herein are intended to provide a further understanding of the present disclosure, and are incorporated in and constitute a part of this specification, schematic embodiments of the disclosure, and together with the description serve to explain the principles of the present disclosure, and do not constitute an improper limitation of the present disclosure. In the drawings:
Fig. 1 is a circuit schematic diagram of a discrete radio frequency power amplifier device according to the related art.
Fig. 2 is a schematic structure diagram of the discrete radio frequency power amplifier device according to the related art.
Fig. 3 is a schematic structure diagram of a radio frequency power amplifier device according to the embodiment of the present disclosure.
Fig. 4 is a perspective view of an inductor assembly in the radio frequency power amplifier device according to the embodiment of the present disclosure.
Fig. 5 is a schematic structure diagram of another radio frequency power amplifier device according to the embodiment of the present disclosure.
Fig. 6 is a side view of the inductor assembly disposed on a grounded capacitor device in the radio frequency power amplifier device according to the embodiment of the present disclosure.
Fig. 7 is a circuit schematic diagram of the radio frequency power amplifier device according to the embodiment of the present disclosure.
Fig. 8 is a schematic structure diagram of the grounded capacitor device in the radio frequency power amplifier device according to the embodiment of the present disclosure.
Fig. 9 is a top view of the grounded capacitor device in the radio frequency power amplifier device according to the embodiment of the present disclosure.

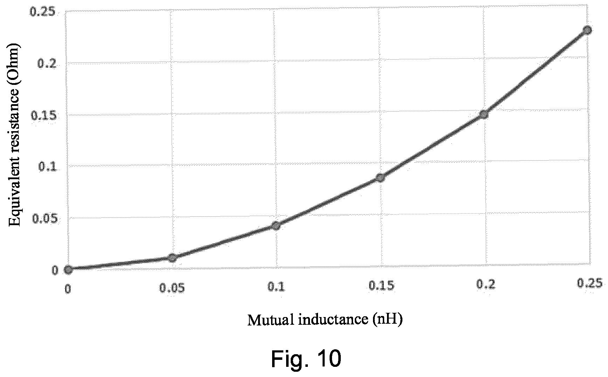

Fig. 10 is a relationship diagram between the mutual inductance and the equivalent resistance in the radio frequency power amplifier device.

REFERENCES IN THE DRAWINGS:

In the related art: 1p-input matching capacitor chip; 2p-active device; 3p-grounded capacitor device;
11-first lead wire; 12-second lead wire; 13-third lead wire; 14-fourth lead wire;
In the present embodiments: 1-input matching capacitor chip; 2-active device; 3-grounded capacitor device; 4-inductor assembly; 5-frame substrate; 6-output matching network; 21-first bonding wire; 22-second bonding wire; 23-third bonding wire; 24-fourth bonding wire; 25-fifth bonding wire;
31-first electrode layer; 32-second electrode layer; 33-base; 34-capacitor; 35-conductive post;
41-inductor base; 42-through hole; 43-metal wire; 44-inductor input electrode; 45-inductor output electrode.

### DETAILED DESCRIPTION OF THE EMBODIMENTS

In order to make technical solutions and advantages of embodiments of the disclosure clearer, exemplary embodiments of the disclosure are described in further detail below in combination with accompanying drawings. Obviously, the described embodiments are only part of the embodiments of the disclosure, not an exhaustive list of all embodiments. It should be noted that the embodiments of the disclosure and features in the embodiments may be combined with each other without conflicts.

A radio frequency power amplifier device provided by the embodiment can improve the problem of electromagnetic coupling caused by parallel lead wires in the conventional solution.

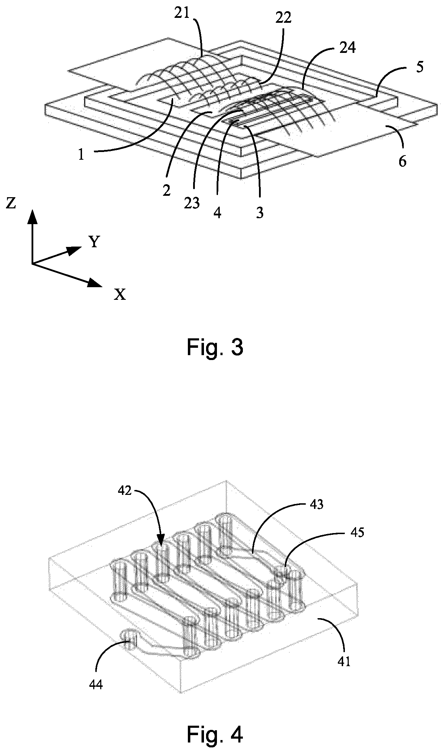

As shown in Fig. 3, the radio frequency power amplifier device provided by the embodiment comprises an active device 2, a grounded capacitor device 3, and an inductor assembly 4. The active device 2 and the grounded capacitor device 3 are spaced apart on a frame substrate 5, specifically arranged and spaced apart along the first direction (i.e., the X direction) in sequence.

The inductor assembly 4 is disposed on the grounded capacitor device 3, and the inductor assembly 4 is connected between the active device 2 and the grounded capacitor device 3. The inductor assembly 4 can partially replace the equivalent inductance formed by the third lead wire 13 in the conventional solution. The active device 2 and the inductor assembly 4 are connected by a short bonding wire. The inductor assembly 4 and the grounded capacitor device 3 can be connected by a bonding wire, and can also be directly connected by a welding pad.

The inductor assembly 4 comprises: an inductor base and a conductive wire. The inductor base is provided with a plurality of through holes penetrating the thickness of the inductor base, and the conductive wire interleavedly passes through the plurality of through holes on two sides of the inductor base from side to side by turns, to form an inductor.

In addition, the connection of other devices can refer to the conventional solution. For example, the radio frequency power amplifier device further comprises: an input matching capacitor chip 1. The input matching capacitor chip 1 and an input port are electrically connected by a first bonding wire 21, the input matching capacitor chip 1 and the active device 2 are electrically connected by a second bonding wire 22, the active device 2 and the inductor assembly 4 are electrically connected by a third bonding wire 23, and the active device 2 and an output port are electrically connected by a fourth bonding wire 24.

The inductor assembly 4 can partially replace the equivalent inductance formed by the third lead wire 13 of the conventional solution, so that the length of the third bonding wire 23 is short, which is capable of reducing the parallel components between the third bonding wire 23 and the fourth bonding wire 24, so as to reduce the electromagnetic coupling of the inductance formed by the third bonding wire 23 and the fourth bonding wire 24, to reduce the loss of the output signal, and improve the power amplifier efficiency.

The technical solution provided by the embodiment, the radio frequency power amplifier device comprises: the active device, the grounded capacitor device, and the inductor assembly; the inductor assembly is disposed on the grounded capacitor device; the inductor assembly is connected between the active device and the grounded capacitor device, the inductor assembly comprises: the inductor base and the conductive wire; the inductor base is provided with a plurality of through holes penetrating the thickness of the inductor base, and the conductive wire interleavedly passes through the plurality of through holes on two sides of the inductor base from side to side by turn, to form an inductor with a certain three-dimensional space, which is capable of improving the electromagnetic coupling problem due to the two bonding wires existing the parallel components in the conventional solution, so as to reduce the loss of the output signals, and improve the power amplifier efficiency.

As shown in Fig. 4, the inductor assembly 4 provided by the embodiment can adopt the implementation as follows: the inductor base 41 can adopt a cubic shape, where the height size is smaller than the length size and smaller than the width size, and the height direction is defined as a thickness direction of the inductor base 41. At least two rows of through holes 42 are disposed along the thickness direction of the inductor base 41, and the conductive interleavedly wire passes through the at least two rows of through holes from side by side in the arrangement order of the through holes, to form the inductor.

The above inductor assembly 4 can be formed in a certain kind of low resistance base having a 3D space structure, most of the magnetic field lines can pass through a space surrounded by the spiral metal, and the magnetic field strength of the space being surrounded is the strongest. Placing an inductor on a low resistance base, the magnetic field distribution can not change much. The places with the strongest magnetic field strength are still concentrated inside the inductor. Correspondingly, the eddy current generated by the inductor on the low resistance substrate is less. By simulation, it is found that the Q value of a 3D inductor can be about 70. By placing the 3D inductor on a low resistance substrate, the Q value drops to about 50, but is still higher than the Q value of a planar inductor directly made on the low resistance substrate.

The low resistance substrate can be selected from a silicon carbide substrate, a silicon nitride substrate, a glass base, or the like, and the glass base is taken as an example in the embodiment. Specifically, the conductive wire is a metal wire 43. As shown in Fig. 4, a plurality of through holes 42 penetrating the thickness are made in the glass base, and the metal wire 43 is made on the upper surface and the lower surface of the glass base, to form a 3D inductor, such as a 3D spiral inductor. The 3D inductor adopting the glass base serves as the low resistance substrate, has a lower loss, and has a lower cost.

Specifically, the inductor base 41 is provided with two rows through holes 42, the metal wire 43 passes upward the first through hole of the first row, then passes downward the first through hole of the second row, then passes upward the second through hole of the first row, then passes downward the second through hole of the second row, and so on until passes through the last through holes of the two rows.

In a case where the glass base is provided with one 3D inductor, the inductor assembly 4 comprises an inductor input electrode 44 and an inductor output electrode 45. The inductor input electrode 44 is electrically connected to the active device 2, and the inductor output electrode 45 is electrically connected to the grounded capacitor device 3. Specifically, the two ends of the glass base are provided with two electrodes through holes respectively, and two ends of the metal wire 43 pass through the electrode through holes to form the inductor input electrode 44 and the inductor output electrode 45, respectively.

The inductor input electrode 44 and the inductor output electrode 45 can be disposed on the same side of the inductor assembly 4, or disposed on two sides of the inductor assembly 4, respectively. The embodiment takes that the inductor input electrode 44 and the inductor output electrode 45 are disposed on the same side of the inductor assembly 4 as an example to describe.

One implementation is as follows: the directions are shown as Fig. 3, the inductor input electrode 44 and the inductor output electrode 45 are disposed above the grounded capacitor device 3 (i.e., the direction of the inductor input electrode 44 and the inductor output electrode 45 away from the grounded capacitor device 3, the face-up direction), and the inductor assembly 4 is disposed on the grounded capacitor device 3. By the short bonding wire, the inductor input electrode 44 and the inductor output electrode 45 are electrically connected to the corresponding electrode welding pads of the base of the grounded capacitor device 3. The electrode welding pads electrically connected to the inductor input electrode 44 are further electrically connected to the active device 2 by the third bonding wire 23, and the electrode welding pads electrically connected to the inductor output electrode 45 are further electrically connected to a first electrode plate of the grounded capacitor device 3 by the bonding wire. Or, the above inductor input electrode 44 can be electrically connected to the active device 2 directly by the bonding wires, and the electrode welding pads corresponding to the inductor input electrode 44 on the grounded capacitor device 3 are not required.

Another implementation is as follows: the inductor input electrode 44 and the inductor output electrode 45 are disposed below the grounded capacitor device 3 (i.e., the direction of the inductor input electrode 44 and the inductor output electrode 45 facing the grounded inductor device 3, the flip direction), and the inductor assembly 4 is disposed on the grounded capacitor device 3. Each of the bottom of the inductor input electrode 44 and the inductor output electrode 45 is connected to a conductive post 35, and fixed and electrically connected to the corresponding welding pad of the grounded capacitor device 3 by the conductive post 35. The electrode welding pads electrically connected to the inductor input electrode 44 are electrically connected to the active device 2 by the third bonding wire 23, and the electrode welding pads electrically connected to the inductor output electrode 45 are directly electrically connected to the first electrode plate of the grounded capacitor device 3 by wiring of the base of the grounded capacitor device 3. This solution does not require the wire bonding operation for the inductor assembly 4, further improving the interference due to the parallel components of the bonding wires, and further improving the device performance.

The wiring of the base of the grounded capacitor device 3 is copper wires, the conductive post s 35 are copper posts, and the inductor input electrode 44 and the inductor output electrode 45 are copper electrodes.

For the above solution, the radio frequency power amplifier device further comprises: an output matching network 6. The active device 2, the grounded capacitor device 3, and the output matching network 6 are spaced apart along the first direction (i.e., the X direction). The active device 2 is further electrically connected to the output matching network 6 by the bonding wire (a fourth bonding wire 24) across the grounded capacitor device 3 to lead out the electrical signal of the active device 2.

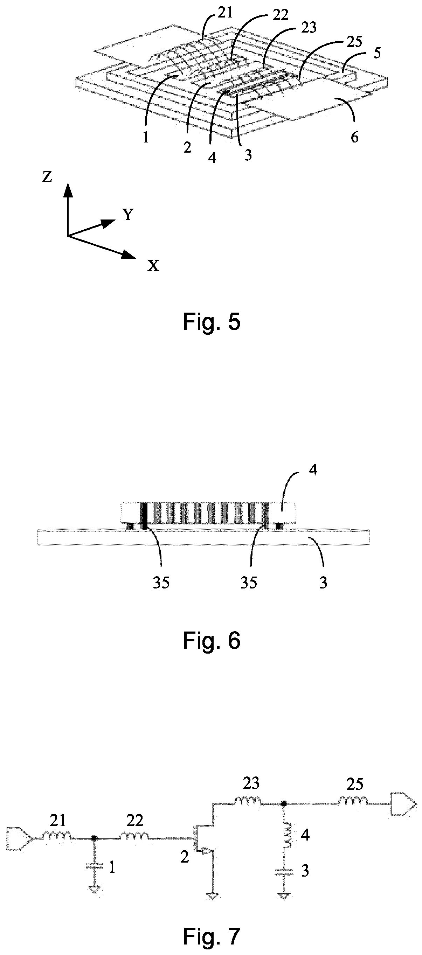

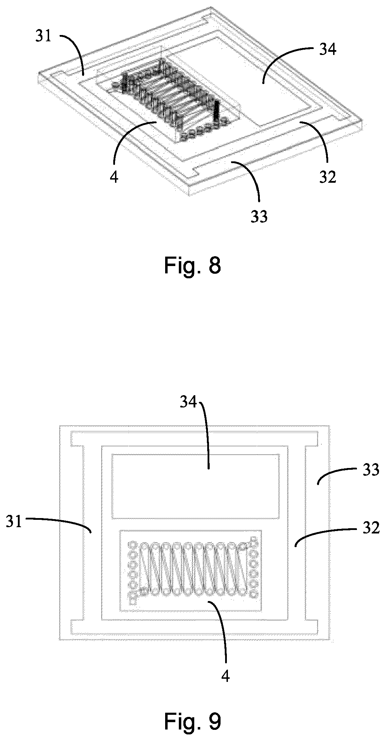

On the basis of the above technical solution, another implementation is provided in the embodiment, as shown in Figs. 5 to 9, the grounded capacitor device 3 comprises: a base 33 and a capacitor 34 formed on the base 33. The inductor assembly 4 is disposed on the base 33, and is spaced apart along a second direction (i.e., the Y direction) from the capacitor 34.

The base 33 of the grounded capacitor device 3 is further provided with a first electrode layer 31 and a second electrode layer 32, and the first electrode layer 31 and the second electrode layer 32 are electrically connected. The first electrode layer 31 is located at an end of the base 33 close to the active device 2, the first electrode layer 31 is electrically connected to the active device 2 by the bonding wire (the third bonding wire 23), and the first electrode layer 31 is further electrically connected to the inductor assembly 4. The second electrode layer 32 is located at an end of the base 33 away from the active device 2, and the second electrode layer 32 is electrically connected to the output matching network 6 by a bonding wire (a fifth bonding wire 25). Fig. 7 is an equivalent circuit schematic diagram of the solution shown in Fig. 5.

In addition, the capacitor 34 and the inductor assembly 4 are disposed between the first electrode layer 31 and the second electrode layer 32, the first electrode layer 31 and the second electrode layer 32 are located at the outer side, so as to be convenient to connect the bonding wire, and no parallel component between the bonding wires.

In the above solution, the signal of the active device 2 is led to the grounded capacitor device 3 by the third bonding wire 23, then led through the first electrode layer 31 and the second electrode layer 32 in sequence, and led out by the fifth bonding wire 25, the third lead wire 13 of the conventional solution is completely replaced, thus eliminating the electromagnetic coupling of the inductance formed by the parallel components between the bonding wires, and reducing the loss of the output signal, and improving the power amplifier efficiency.

The above device adopts an air cavity packaging manner. The air cavity packaging is a hollow sealed tube shell with a heat dissipation flange at the bottom, one or more thin metal pins on the left and right sides, and a ceramic or polymer material cover at the top. The flange of the package tube shell at the bottom has good heat dissipation and grounding ability. The active device 2 and the matching capacitor chips for input and output are welded on the flange by sintering. The inner cavity is conducive to mounting bonding wires and reducing parasitism of active FET transistors.

The active device 2 can be a field effect transistor (FET), a laterally diffused metal oxide semiconductor (LDMOS), or a field effect transistor made of gallium nitride (GaN).

As shown in Fig. 1, the inductor formed by the third lead wire 13 and the fourth lead wire 14 has the mutual inductance effect in the conventional solution. The greater the mutual inductance effect, the larger the equivalent resistance, resulting in a large loss of the output signal and reducing power amplifier efficiency. In the present disclosure, electromagnetic coupling does not exist between the bonding wires, that is no mutual inductance effect, which directly reduces the equivalent resistance, reduces the loss of the output signal, and improves the power amplifier efficiency.

By testing the above radio frequency power amplifier device, the efficiency is about 2% higher than the conventional solution, and does not affect the gain of the amplifier.

Based on the above technical solution, the embodiment further provides a manufacturing method of the radio frequency power amplifier device, comprising:
Step 1: disposing an active device and a grounded capacitor device on a frame substrate.

In this step, the electrodes of the active device are welded to the electrodes of the grounded capacitor device.

Step 2: disposing an inductor assembly on the grounded capacitor device to electrically connect the inductor assembly and the grounded capacitor device.

In this step, specifically, the inductor input electrode and the inductor output electrode of the inductor assembly are connected to the conductive post s, and then the conductive post s are welded to the electrode welding pads corresponding to the grounded capacitor device.

Step 3: connecting the inductor assembly and the active device with a plurality of bonding wires.

The other devices are connected to the corresponding bonding wires. For example, in the above solution, the first bonding wire 21 is connected between the input matching capacitor chip 1 and the input port, the second bonding wire 22 is connected between the input matching capacitor chip 1 and the active device 2, and the third bonding wire 23 is connected between the active device 2 and the inductor assembly 4.

The solution refers to Fig. 3, the fourth bonding wire 24 is connected between the active device 2 and the output matching network 6. Or, the solution refers to Fig. 5, the fifth bonding wire 25 is connected between the grounded capacitor device 3 and the output matching network 6.

The radio frequency power amplifier device manufactured by the above manufacturing method can improve the electromagnetic coupling problem due to the two bonding wires existing parallel components in the conventional solution, so as to reduce the loss of the output signals, and improve the power amplifier efficiency.

In the descriptions of the disclosure and the embodiments thereof, it is to be understood that orientation or position relationships indicated by terms "center", "longitudinal", "lateral", "length", "width", "thickness", "on", "under", "front", "back", "left", "right", "vertical", "horizontal", "top", "bottom", "in", "out" and the like are orientation or position relationships shown in the drawings, are adopted not to indicate or imply that indicated devices or components must be in specific orientations or structured and operated in specific orientations but only to conveniently describe the disclosure and simplify descriptions, and thus should not be understood as limits to the disclosure.

In addition, the terms "first" and "second" are used for descriptive purposes only and are not to be construed as indicating or implying relative importance or implicitly specifying the quantity of the indicated technical features. Thus, features defined with "first" or "second" may explicitly or implicitly include one or more such features. In the description of this application, the term "a plurality of" means at least two, such as two, three, etc., unless explicitly defined otherwise.

In the disclosure, unless otherwise definitely specified and limited, terms "mount", "mutually connect", "connect", "fix", and the like should be broadly understood. For example, the terms may refer to the fixed connection and may also refer to the detachable connection or integration. The terms may refer to the mechanical connection, may also refer to the electrical connection, or may also refer to communication. The terms may refer to direct mutual connection, may also refer to indirect connection through a medium, and may refer to communication in two components or an interaction relationship between the two components. Those having ordinary skill in the art may understand specific meanings of the above terms in the embodiments of the present disclosure according to specific situations.

Although some optional embodiments of the disclosure have been described, those skilled in the art, once learning about basic creative concepts, may make other variations and modifications to these embodiments. Therefore, it is intended that the appended claims are explained to include the optional embodiments and all the variations and modifications falling within the scope of the disclosure.

It is apparent that those skilled in the art may make various modifications and transformations to the disclosure without departing from the spirit and scope of the disclosure. Therefore, if these modifications and transformations of the disclosure fall within the scope of the claims of the disclosure and equivalent technologies thereof, the disclosure is also intended to include these modifications and transformations.

## Claims

1. A radio frequency power amplifier device, comprising: an active device (2), a grounded capacitor device (3), and an inductor assembly (4);
wherein the inductor assembly (4) is disposed on the grounded capacitor device (3), and the inductor assembly (4) is connected between the active device (2) and the grounded capacitor device (3); and
the inductor assembly (4) comprises: an inductor base (41) and a conductive wire; the inductor base (41) is provided with a plurality of through holes (42) penetrating a thickness of the inductor base (41), and the conductive wire interleavedly passes through the plurality of through holes (42) on two sides of the inductor base (41) from side to side by turns, to form an inductor.

2. The radio frequency power amplifier device according to claim 1, wherein the inductor base (41) is a glass base.

3. The radio frequency power amplifier device according to claim 1, wherein
at least two rows of through holes (42) are disposed on the inductor base (41); and
the conductive wire interleavedly passes through the at least two rows of through holes (42) from side to side in an arrangement order of the through holes (42), to form the inductor.

4. The radio frequency power amplifier device according to any one of claims 1 to 3, wherein the inductor assembly (4) comprises an inductor input electrode (44) and an inductor output electrode (45);
the inductor assembly (4) is fixed to the grounded capacitor device (3) along a direction of the inductor output electrode (45) facing the grounded capacitor device (3);
the inductor output electrode (45) is connected to a first electrode plate of the grounded capacitor device (3) by a conductive post (35); and
two ends of the conductive wire form the inductor input electrode (44) and the inductor output electrode (45) respectively.

5. The radio frequency power amplifier device according to claim 4, wherein
the inductor input electrode (44) is electrically connected to the active device (2) by a plurality of bonding wires.

6. The radio frequency power amplifier device according to any one of claims 1 to 5 further comprising:
an output matching network (6);
wherein the active device (2), the grounded capacitor device (3), and the output matching network (6) are spaced apart along a first direction.

7. The radio frequency power amplifier device according to claim 6, wherein
the active device (2) is further electrically connected to the output matching network (6) by the bonding wire across the grounded capacitor device (3).

8. The radio frequency power amplifier device according to claim 6, wherein
a base (33) of the grounded capacitor device (3) is further provided with a first electrode layer (31) and a second electrode layer (32), and the first electrode layer (31) and the second electrode layer (32) are electrically connected;
the first electrode layer (31) is located at one end of the base (33) close to the active device (2), the first electrode layer (31) is electrically connected to the active device (2) by the bonding wire, and the first electrode layer (31) is further electrically connected to the inductor assembly (4); and
the second electrode layer (32) is located at one end of the base (33) away from the active device (2), and the second electrode layer (32) is electrically connected to the output matching network (6) by the bonding wire.

9. The radio frequency power amplifier device according to claim 8, wherein
the grounded capacitor device (3) comprises: a base (33) and a capacitor (34) formed on the base (33); and
the inductor assembly (4) is disposed on the base (33) and is spaced apart along a second direction from the capacitor (34).

10. The radio frequency power amplifier device according to claim 9, wherein the capacitor (34) and the inductor assembly (4) are located between the first electrode layer (31) and the second electrode layer (32).

11. A manufacturing method of the radio frequency power amplifier device according to claim 4, comprising:
disposing the active device (2) and the grounded capacitor device (3) on a frame substrate (5);
disposing the inductor assembly (4) on the grounded capacitor device (3), to electrically connect the inductor assembly (4) and the grounded capacitor device (3); wherein the inductor assembly (4) comprises: the inductor base (41) and the conductive wire; the inductor base (41) is provided with a plurality of through holes (42) penetrating the thickness of the inductor base (41); and the conductive wire interleavedly passes through the plurality of through holes (42) on two sides of the inductor base (41) from side to side by turn, to form the inductor; and
connecting the inductor assembly (4) and the active device (2) with a plurality of bonding wires.

12. The manufacturing method according to claim 11, wherein the step of disposing the active device (2) and the grounded capacitor device (3) on the frame substrate (5) comprises:
welding electrodes of the active device (2) to electrodes of the grounded capacitor device (3).

13. The manufacturing method according to claim 11, wherein the step of disposing v inductor assembly (4) on the grounded capacitor device (3) comprises:
connecting the inductor input electrode (44) and the inductor output electrode (45) of the inductor assembly (4) to the conductive posts (35), and
welding the conductive posts (35) to the electrode welding pads corresponding to the grounded capacitor device (3).

14. The manufacturing method according to claim 11, wherein the step of connecting the inductor assembly (4) and the active device (2) with a plurality of bonding wires comprises:
connecting a first bonding wire (21) between an input matching capacitor chip (1) and the input port;
connecting a second bonding wire (22) between the input matching capacitor chip (1) and the active device (2), and
connecting a third bonding wire (23) between the active device (2) and the inductor assembly (4).

15. The manufacturing method according to claim 14, wherein the step of connecting the inductor assembly (4) and the active device (2) with a plurality of bonding wires further comprises:
connecting a fourth bonding wire (24) between the active device (2) and the output matching network (6); or
connecting a fifth bonding wire (25) between the grounded capacitor device (3) and the output matching network (6).
